Europäisches Patentamt

(19) European Patent Office

Office européen des brevets

(11) Veröffentlichungsnummer: **0 252 279 B1**

(12) **EUROPÄISCHE PATENTSCHRIFT**

(45) Veröffentlichungstag der Patentschrift:
06.02.91 Patentblatt 91/06

(51) Int. Cl.⁵: **C30B 33/00, C30B 15/00**

(21) Anmeldenummer: 87107892.9

(22) Anmeldetag: 01.06.87

(54) **Verfahren und Vorrichtung zum Abtrennen von für Solarzellen verwendbaren scheibenförmigen Siliziumkörpern von einem nach dem sogenannten horizontalen Bandziehverfahren hergestellten Siliziumband.**

(30) Priorität: 06.06.86 DE 3619018

(43) Veröffentlichungstag der Anmeldung:
13.01.88 Patentblatt 88/02

(45) Bekanntmachung des Hinweises auf die
Patenterteilung:
06.02.91 Patentblatt 91/06

(84) Benannte Vertragsstaaten:
DE FR GB IT

(56) Entgegenhaltungen:
EP-A- 0 170 119
FR-A- 2 493 350
GB-A- 2 139 917

(73) Patentinhaber: Siemens Aktiengesellschaft
Wittelsbacherplatz 2
D-8000 München 2 (DE)

(72) Erfinder: Falckenberg, Richard, Dr.
Hofen 21
D-8952 Walde (DE)
Erfinder: Hoyler, Gerhard, Dipl.-Phys.
Münchberger Strasse 11a
D-8000 München 90 (DE)
Erfinder: Grabmaier, Josef, Dr.
Am Seefeld 17
D-8137 Berg (DE)

## Beschreibung

Verfahren und Vorrichtung zum Abtrennen von für Solarzellen verwendbaren scheibenförmigen Siliziumkörpern von einem nach dem sogenannten horizontalen Bandziehverfahren hergestellten Siliziumband.

Die Erfindung betrifft ein Verfahren zum Abtrennen von für Solarzellen verwendbaren scheibenförmigen Siliziumkörpern von einem nach dem sogenannten horizontalen Bandziehverfahren hergestellten Siliziumband, bei dem als Trägerkörper und Kristallisationskeimbildner für die das Siliziumband erzeugende Schmelze ein in Ziehrichtung des Bandes laufendes, vorzugsweise aus Graphitfäden bestehendes Gewebe verwendet wird, welches tangierend über die in einer Wanne befindliche Siliziumschmelze gezogen wird und bei dem über der Schmelze und unter der Schmelze Heizquellen angeordnet sind, die so aufeinander abgestimmt sind, daß unter Berücksichtigung der Abstrahlungsverluste der Schmelzenoberfläche das Siliziumband in gleichmäßiger Dicke erstarrt, bevor es dann kontinuierlich seitlich von der Schmelze abgezogen wird.

Eine solche Verfahrensweise ist beispielsweise aus der europäischen Patentanmeldung 0 170 119 bekannt. Dabei werden mit hoher Ziehgeschwindigkeit im Bereich von m/min kontinuierlich Siliziumbänder hergestellt, die vor ihrer Weiterverarbeitung zu Solarzellen in die entsprechenden Abschnitte noch zerteilt werden müssen.

Um die Kontinuität des Ziehprozesses nicht zu stören, muß das Zertrennen in die Abschnitte bestimmter Länge während des Ziehvorganges und bei unveränderter Ziehge- schwindigkeit erfolgen. Durch den Trennprozeß darf das Band nicht in Erschütterungen oder Vibrationen versetzt werden, weil dadurch der Wachstumsprozeß gestört würde. Wachstumsstörungen führen zu einer Verminderung des Wirkungsgrades der aus diesem Material gefertigten Solarzellen.

Die Aufgabe, die der Erfindung zugrundeliegt, besteht nun darin, eine störungsfreie Trennmethode zu finden, die sich zwanglos in den kontinuierlichen Herstellungsprozeß einfügt.

Diese Aufgabe wird bei einem Verfahren der eingangs genannten Art dadurch gelöst, daß in bestimmten, vorgegebenen Abständen, die der Größe der Siliziumbandabschnitte für die Solarzellen entsprechen, die Abstrahlungsverluste über der Schmelzenoberfläche durch synchron mitlaufende Abschirmkörper soweit verringert werden, daß örtlich begrenzt eine Erstarrung nicht stattfindet und sich dadurch im Siliziumband ein Trennstreifen ausbildet.

Es liegt im Rahmen der Erfindung, daß als Abschirmkörper brückenförmige Gebilde aus hitzebeständigem, den elektrischen Strom gut leitendem Material verwendet werden, welche auf die nicht zur Kristallisation verwendeten Außenstreifen des Graphitgewebes aufgesetzt werden und so die Schmelzenoberfläche überspannen.

Die Erfindung behifft auch eine Vorrichtung zur Durchführung des Verfahrens. Die Merkmale dieser Vorrichtung sind in Anspruch 8 wiedergegeben.

Weitere Ausgestaltungen der Erfindung ergeben sich aus den Unteransprüchen.

Folgende Überlegungen haben zu der Erfindung geführt : Beim horizontalen Bandziehverfahren entsteht ein Siliziumband dadurch, daß die Oberfläche einer Siliziumschmelze gekühlt wird und zu einer dünnen Schicht erstarrt. Bei geeigneter Steuerung des Erstarrungsvorganges kann die Schicht kontinuierlich in Form eines Bandes seitlich von der Schmelze abgezogen werden. Zur Stabilisierung des Kristallisationsprozesses wird ein aus einem gegenüber der Siliziumschmelze einen höheren Emissionsfaktor E aufweisendes Material als Trägerkörper, zum Beispiel ein Carbonfasernetz benützt. Die zur Erstarrung der Siliziumoberflächen notwendige Kühlung geschieht im wesentlichen durch Abstrahlung.

Nach dem Gedanken der Erfindung werden in gewissen Abständen, die der Größe der gewünschten Siliziumbandabschnitte entsprechen, die Abstrahlungsverluste der Schmelzenoberfläche soweit verringert, daß eine Erstarrung nicht mehr erfolgt. Dies wird dadurch erreicht, daß ein Körper mit dem entstehenden Siliziumband mitbewegt wird, der die zur Erstarrung erforderliche Wärmeabstrahlung der Schmelzenoberfläche verhindert. Im Prinzip können hierzu vier Eigenschaften des mitbewegten Körpers benützt werden, nämlich

1. die Eigentemperatur,
2. der Emissions- bzw. Absorptionsgrad $E_K$,
3. das Reflexionsvermögen und
4. seine Formgebung.

Die von der Schmelze abgestrahlte Leistung P pro Flächeneinheit ergibt sich aus dem Stefan-Boltzmannschen Gesetz zu

$$P = \frac{E_S \cdot E_K}{E_S + E_K - E_S \cdot E_K} \; \sigma \; (T_S^4 - T_K^4), \qquad (1)$$

wobei $E_S$ das Emissionsvermögen der Schmelze, $E_K$ das des abdeckenden Körpers K, $\sigma$ die Stefan-Boltzmannsche Konstante, $T_S$ die Temperatur der Schmelze und $T_K$ die Temperatur des abdeckenden Körpers ist.

Ersetzt man in Gleichung (1) $E_S$ durch das Emissionsvermögen des festen Siliziums $E_F$, so erhält man die von der kristallisierten Oberfläche abgestrahlte Leistung. Bei nicht abgedeckter Oberfläche ist bei der Temperatur des Schmelzpunktes $T_S$ die abgestrahlte Leistung des festen Siliziums um ungefähr 7 Watt/cm$^2$ höher als die des flüssigen Siliziums.

Leitet man bei gleichbleibender Heizleistung $P_H$ die Kristallisation durch Kontaktierung der Schmelzenoberfläche mit dem in horizontaler Richtung bewegten Carbonfasernetz ein, so vergrößert sich die abgestrahlte Leistung P um ungefähr 7 Watt/cm$^2$. Soweit dieser Betrag nicht zu einer Temperaturerniedrigung führt, wird er von der freiwerdenden latenten Wärme $P_L$ geliefert :

$$P = P_H + P_L \qquad\qquad (2)$$

Bei konstanter Heizerleistung ist daher $P_L \leq 7$ Watt/cm$^2$. Verhindert man die Abführung des von der latenten Wärme stammenden Anteils $P_L$, so kann eine Kristallisation nicht mehr stattfinden.

Im folgenden wird die Erfindung anhand von zwei Ausführungsbeispielen und der Figuren 1 bis 3 noch näher erläutert. Dabei zeigt

die Figur 1 eine Anordnung, die das eben beschriebene Prinzip der Erfindung erläutern soll und

die Figuren 2 und 3 Vorrichtungen zur Durchführung des Verfahrens in schematischer Darstellung.

In allen Figuren gelten für gleiche Teile gleiche Bezugszeichen.

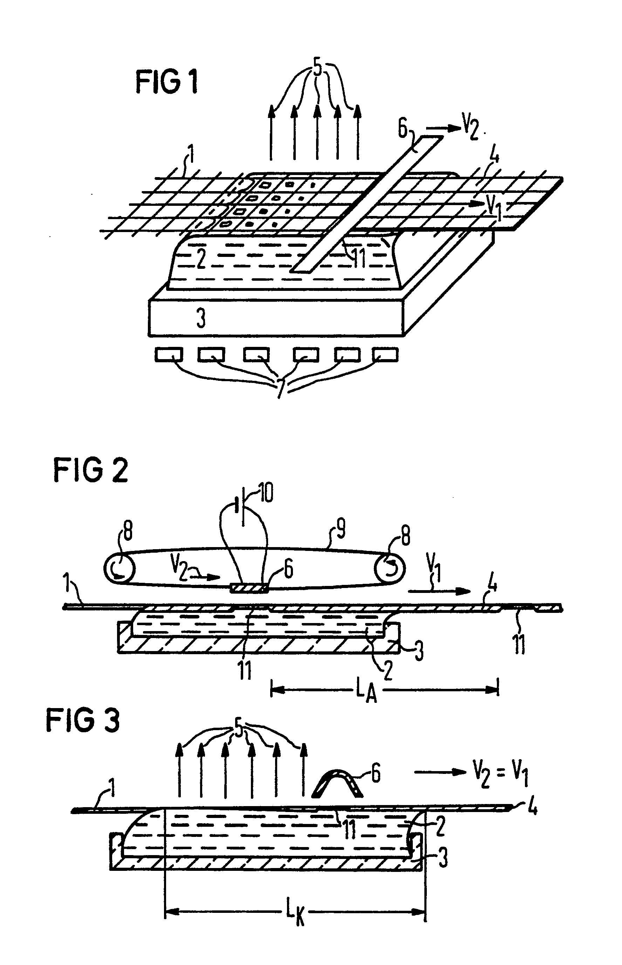

In Figur 1 gelten folgende Bezugszeichen :

1 = Carbonfasernetz, bewegt mit der Geschwindigkeit $v_1$

2 = Siliziumschmelze

3 = die die Siliziumschmelze aufnehmende Wanne aus Quarz

4 = kristallisiertes Siliziumband ($v_1$)

5 = Abstrahlung der Schmelzwärme

6 = Abschirmungskörper aus zum Beispiel einem streifenförmigen Molybdänblech, bewegt mit der Geschwindigkeit $v_2$

7 = Heizer (der besseren Übersicht wegen sind die über der Schmelze angeordneten Heizer nicht dargestellt)

11= Trennstelle.

In der Anordnung gilt $v_2 = v_1$ ; die Pfeile zeigen die Ziehrichtung an.

Die Figur 2 zeigt in schematischer Darstellung eine kontinuierlich arbeitende Anordnung, bei der zur Realisierung des Erfindungsgedankens streifenförmige Graphitkörper 6 verwendet werden. Diese Graphitkörper 6 werden synchron auf einem Band 9 über Ablenkrollen 8 mittels eines zusätzlichen Getriebes (nicht dargestellt) mit dem zu beschichtenden Graphitträgerkörper 1 mit der Geschwindigkeit $v_2$ mitbewegt. Die Graphitkörper 6 werden über eine Stromquelle 10 auf eine Temperatur $T_K$ hochgeheizt. Bei $T_K$ ist die Eigenstrahlung des Körpers 6 auf das darunterliegende Silizium so groß, daß eine Kristallisation der Schmelze 2 an dieser Stelle 11 nicht möglich ist. Die Stelle 11 ist dann die Trennstelle.

Zur Aufheizung der Körper 6 kann auch direkt die von der Siliziumschmelze 2 ausgehende Wärmestrahlung 5 benutzt werden. Die Körper 6 müssen dann durch einen hohen Absorptionsgrad E gekennzeichnet und so ausgebildet sein, daß ihre Wärmekapazität klein ist und Wärmeverluste auf der der Schmelze abgewandten Seite des Körpers 6 verhindert werden. Praktisch verwendet werden dünne Graphitlamellen oder Graphitgewebestreifen, die einseitig mit Graphitfilz wärmeisoliert sind (in der Figur nicht dargestellt).

Der eingezeichnete Abstand $L_A$ in Figur 2 bezeichnet die Abschnittslänge, das heißt die Länge des abzutrennenden scheibenförmigen Siliziumkörpers.

Figur 3 : Körper 6 mit starkem Reflexionsvermögen, wie zum Beispiel Molybdänbleche, benötigen im allgemeinen keine Beheizung. Zweckmäßigerweise werden solche Molybdänkörper 6 verwendet, deren Querschnitte die Form einer Parabel haben. Auf diese Weise wird die reflektierte Strahlung 5 auf die Brennlinie konzentriert und man erhält ein Siliziumband 4 mit besonders schmalen Trennstreifen 11.

Die Wirkung der Reflexion kann nachlassen, wenn nach längerem Gebrauch der reflektierenden Körper 6 deren Oberflächen mit Silizium bedampft sind. Zweckmäßigerweise wird daher die aufgedampfte Siliziumschicht nach jedem Durchgang, zum Beispiel mittels Plasmaätzen entfernt.

Eine zusätzliche Wirkung der Körper 6 zeigt sich, wenn nicht im Vakuum, sondern unter Schutzgasatmosphäre gearbeitet wird. Die zur Abkühlung der Siliziumoberfläche beitragende Konvektionsströmung wird durch die Körper 6 verringert oder - wie bei der parabelförmigen Ausführung in Figur 3 - weitgehend unterdrückt.

Wie bereits erwähnt (siehe Figur 1), müssen die Körper 6 mit dem kristallisierenden Band 1, 4 synchron mitbewegt werden ($v_2 = v_1$). Das erfolgt zweckmäßigerweise so, daß die Körper 6 als Brücken ausgebildet werden, die auf die nicht zur Kristallisation verwendeten Außenstreifen des Carbonfasernetzes 1 aufgesetzt werden und so die Schmelze 2 überspannen. Nach Durchlaufen der Kristallisationszone werden sie mit Hilfe einer gabelartigen Vorrichtung vom beschichteten Trägerkörper 1, 4 abgehoben und in die Ausgangsposition zurückbefördert (in den Figuren nicht dargestellt).

Ist die Abschnittslänge $L_A$ kürzer als die Kristallisationslänge $L_K$ (siehe Figur 3), so werden zweckmäßig gleichzeitig mehrere Abdeckkörper 6 benötigt, die synchron ($v_2 = v_1$) mit dem Siliziumband 4 mitbewegt werden.

## Ansprüche

1. Verfahren zum Abtrennen von für Solarzellen verwendbaren scheibenförmigen Siliziumkörpern von einem nach dem sogenannten horizontalen Bandziehverfahren hergestellten Siliziumband, bei dem als Trägerkörper (1) und Kristallisationskeimbildner für die das Siliziumband (4) erzeugende Schmelze (2) ein in Ziehrichtung des Bandes (1) laufendes, vorzugsweise aus Graphitfäden bestehendes Gewebe verwendet wird, welches tangierend über die in einer Wanne (3) befindliche Siliziumschmelze (2) gezogen wird und bei dem über der Schmelze (2) und unter der Schmelze (2) Heizquellen (7) angeordnet sind, die so aufeinander abgestimmt sind, daß unter Berücksichtigung der Abstrahlungsverluste (5) der Schmelzenoberfläche (2) das Siliziumband (4) in gleichmäßiger Dicke erstarrt, bevor es dann kontinuierlich seitlich von der Schmelze (2) abgezogen wird, **dadurch gekennzeichnet,** daß in bestimmten, vorgegebenen Abständen ($L_A$), die der Größe der Siliziumbandabschnitte für die Solarzellen entsprechen, die Abstrahlungsverluste (5) über der Schmelzenoberfläche (2) durch synchron mitlaufende Abschirmkörper (6) so weit verringert werden, daß örtlich begrenzt eine Erstarrung nicht stattfindet und sich dadurch im Siliziumband (4) ein Trennstreifen (11) ausbildet.

2. Verfahren nach Anspruch 1, **dadurch gekennzeichnet,** daß als Abschirmkörper (6) brückenförmige Gebilde aus hitzebeständigem, den elektrischen Strom gut leitendem Material verwendet werden, welche auf die nicht zur Kristallisation verwendeten Außenstreifen des Graphitgewebes (1) aufgesetzt werden und so die Schmelzenoberfläche (2) überspannen.

3. Verfahren nach Anspruch 1 oder 2, **dadurch gekennzeichnet,** daß als Abschirmkörper (6) streifenförmige, durch Stromdurchgang beheizbare Graphitkörper oder Körper aus Molybdän verwendet werden (Figur 2).

4. Verfahren nach Anspruch 1 oder 2, **dadurch gekennzeichnet,** daß Abschirmkörper (6) verwendet werden, die aus einem, einen hohen Absorptionsgrad aufweisenden Material bestehen und in bezug auf ihre Form eine kleine Wärmekapazität aufweisen.

5. Verfahren nach Anspruch 4, **dadurch gekennzeichnet,** daß als Abschirmkörper (6) dünne Graphitlamellen oder Graphitgewebestreifen verwendet werden, die einseitig mit Graphitfilz wärmeisoliert sind.

6. Verfahren nach Anspruch 1 oder 2, **dadurch gekennzeichnet,** daß Abschirmkörper (6) mit hohem Reflexionsvermögen verwendet werden.

7. Verfahren nach Anspruch 6, **dadurch gekennzeichnet,** daß Abschirmkörper (6) mit parabelförmigem Querschnitt verwendet werden (Figur 3).

8. Vorrichtung zur Durchführung des Verfahrens nach einem der Ansprüche 1 bis 7 mit folgenden Merkmalen :

a) einer, die Siliziumschmelze (2) aufnehmenden, vom Boden beheizbaren Schmelzwanne (3),

b) einer, außerhalb des Schmelzwannenbereiches (2, 3) angeordneten Antriebsvorrichtung, durch welche eine Ziehrichtung ($v_1$) in Winkeln kleiner 10 Grad gegen die Horizontale geneigt einstellbar ist,

c) einer, seitlich über der Schmelzwanne (3) angeordneten Umlenkrolle für das, die Keimbildungszentrum bewirkende, vorzugsweise aus Graphit bestehende Gewebeband (1),

d) ein, mit der Schmelzwanne (3) in Verbindung stehendes Reservoir für die Vorratsschmelze, welches vor der eigentlichen Ziehvorrichtung angeordnet ist,

e) über der Schmelzwanne (3) angeordneten, bezüglich ihrer Stellung zur Schmelzoberfläche (2) regelbaren Reflektoren, **dadurch gekennzeichnet,** daß außerhalb des Schmelzwannenbereiches (2, 3) ein mit streifenförmigen Abschirmkörpern (6) aus hitzebeständigem, den elektrischen Strom gut leitendem Material besetztes Band (9) sowie Antriebsvorrichtungen und Umlenkrollen (8) angeordnet sind, mit deren Hilfe das mit Abschirmkörpern (6) besetzte Band (9) synchron zum zu beschichtenden Trägerkörper (1) mitbewegt wird (Figur 2).

9. Vorrichtung nach Anspruch 8, **dadurch gekennzeichnet,** daß anstelle des synchron mitlaufenden Bandes (9) eine Bestückungsvorrichtung vor der eigentlichen Ziehvorrichtung vorgesehen ist, durch die, die Abschirmkörper (6) in bestimmten Abständen ($L_A$) auf die Außenstreifen des zu beschichtenden Bandes (1) gesetzt werden und daß eine gabelförmige Vorrichtung vorgesehen ist, durch die die Abschirmkörper (6) nach dem Durchlauf durch die Kristallisationszone vom Band (1, 4) wieder abgehoben werden.

## Claims

1. Method for separating disc-shaped silicon bodies, which can be used for solar cells, from a silicon tape produced according to the so-called horizontal tapedrawing method, in which a woven fabric running in the drawing direction of the tape (1) and preferably consisting of graphite threads is utilized as carrier body (1) and as a nucleator for crystallization for the melt (2) which generates the silicon tape, said carrier being drawn across the molten silicon (2) located in a bath (3), and in which heat sources (7) are arranged above the melt (2) and below the melt (2), said heat sources being adjusted in relation to one another in such a way that, taking onto consideration the radiation losses (5) of the melt surface (2), the silicon tape (4) solidifies in a uniform thickness before it is then drawn laterally continuously from the melt (2), characterized in that, at specific, predetermined intervals ($L_A$) which correspond to the size of the silicon tape sections for the solar cells, the radiation losses (5) above the melt surface (2) are reduced, by means of shielding bodies (6) running in synchronism, to such an extent that solidification does not take place on a locally limited basis and as a result a dividing strip (11) is formed in the silicon tape (4).

2. Method according to Claim 1, characterized in that bridge-shaped constructions of heat-resistant material which is a good electrical conductor are used as shielding bodies (6), said shielding bodies being placed on the outer strips, not used for crystallization, of the graphite fabric (1) and so span the surface (2) of the melt.

3. Method according to Claim 1 or 2, characterized in that strip-shaped graphite bodies or bodies of molybdenum are used as shielding bodies (6) (Figure 2).

4. Method according to Claim 1 or 2, characterized in that shielding bodies (6) are used which consist of a material having a high absorption coefficient and a small heat capacity in relation to their shape.

5. Method according to Claim 4, characterized in that thin graphite laminas or graphite fabric strips which are heat-insulated on one side with graphite felt are used as shielding bodies (6).

6. Method according to Claim 1 or 2, characterized in that shielding bodies (6) with high reflectivity are used.

7. Method according to Claim 6, characterized in that shielding bodies (6) with parabolic cross-section are used (Figure 3).

8. Device for carrying out the method according to one of Claims 1 to 7 having the following features :

a) a melting bath (3) which receives the silicon melt (2) and is heatable from the bottom,

b) a drive device arranged outside the melting bath region (2, 3), by means of which device a drawing direction ($v_1$) can be set inclined at angles smaller than 10 degrees to the horizontal,

c) a deflection roller, arranged laterally over the melting bath (3), for the fabric tape (1) which brings about the centre of nucleation and preferably consists of graphite,

d) a reservoir, connected to the melting bath (3), for the melt supply, said reservoir being arranged in front of the actual drawing device,

e) reflectors arranged above the melting bath (3) which can be controlled in respect of their position in relation to the surface (2) of the melt, characterized in that arranged outside the melting bath region (2, 3) are a tape (9), provided with strip-shaped shielding bodies (6) consisting of heat-resistant material with good electrical conductivity, as well as drive devices and deflection rollers (8), with the aid of which the tape (9) provided with shielding bodies (6) can be moved along (Figure 2) synchronously with the carrier body (1) to be coated.

9. Device according to Claim 8, characterized in that, instead of the tape (9) running in synchronism, a component-mounting device is provided before the actual drawing device, by means of which component-mounting device the shielding bodies (6) are placed at specific intervals ($L_A$) onto the outer strips of the tape (1) to be coated, and in that a fork-shaped device is provided by means of which the shielding bodies (6) are lifted off the tape (1, 4) again after passing through the crystallization zone.

## Revendications

1. Procédé de séparation de pastilles de silicium, utilisées pour des cellules solaires, d'un ruban de silicium, fabriqué par ce que l'on appelle le procédé de tirage horizontal d'un ruban, qui consiste à utiliser comme corps de support (1) et, comme agent de formation d'un germe de cristallisation pour le bain fondu (2) produisant le ruban de silicium (4), un tissu s'étendant dans le sens de traction du ruban (1) et, de préférence, en fils de graphite, qui est tiré tangentiellement sur le bain de silicium (2) se trouvant dans une cuve (3), et à disposer, au-dessus du bain (2) et en-dessous du bain (2), des sources de chaleur (7) qui sont adaptées les unes aux autres de façon, qu'en tenant compte des pertes par rayonnement (5) à la surface du bain (2), le ruban de silicium (4) se solidifie en une épaisseur uniforme avant d'être tiré en continu latéralement du bain, caractérisé en ce qu'à certains intervalles ($L_A$) prescrits, qui correspondent à la dimension des tronçons de bandes de silicium pour les cellules solaires, les pertes par rayonnement (5), par la surface du bain (2), sont réduites par un corps de protection ou corps-écran (6) se déplaçant en synchronisme pour qu'il ne se produise pas une solidification limitée localement et qu'il se forme ainsi dans le ruban de silicium (4) une bande de séparation (11).

2. Procédé suivant la revendication 1, caractérisé en ce qu'il consiste à utiliser, comme corps de protection (6), des structures en forme de ponts, en un matériau résistant à la chaleur et bon conducteur du courant électrique, qui sont posées sur les bandes extérieures du tissu en graphite (1) qui ne sont pas utilisées pour la cristallisation et qui recouvrent ainsi la surface du bain (2).

3. Procédé suivant la revendication 1 ou 2, caractérisé en ce qu'il consiste à utiliser, comme corps de protection (6), des corps en graphite ou des corps en molybdène en forme de bandes, pouvant être chauffés par le passage du courant électrique.

4. Procédé suivant la revendication 1 ou 2, caractérisé en ce qu'il consiste à utiliser des corps de protection (6), qui sont en un matériau présentant un grand degré d'absorption et qui présentent une petite capacité calorifique, par rapport à leur forme.

5. Procédé suivant la revendication 4, caractérisé en ce qu'il consiste à utiliser, comme corps de protection (6), des lamelles minces de graphite ou des bandes de tissu de graphite, qui sont calorifugées d'un côté par du feutre de graphite.

6. Procédé suivant la revendication 1 ou 2, car en ce qu'il consiste d'utiliser des corps de protection (6) à grand pouvoir de reflexion.

7. Procédé suivant la revendication 6, caractérisé en ce qu'il consiste à utiliser des corps de protection (6) de section transversale parabolique. (figure 3)

8. Installation pour la mise en oeuvre du procédé suivant l'une des revendications 1 à 7 ayant les caractéristiques suivantes :

a) une cuve (3) de réception d'un bain fondu de silicium (2) et pouvant être chauffée par le fond,

b) un dispositif d'entraînement qui est disposé à l'extérieur de la zone de la cuve pour le bain fondu (2, 3) et grâce auquel on peut incliner la direction de tirage ($v_1$) suivant des angles inférieurs à 10 degrés par rapport à l'horizontale,

c) un galet de renvoi disposé latéralement au-dessus de la cuve pour le bain fondu (3) et destiné à renvoyer la bande de tissu (1), de préférence en graphite, provoquant la formation du centre du germe,

d) un réservoir pour du bain fondu en réserve, qui communique avec la cuve pour le bain fondu (3), et qui est disposé en aval du dispositif de tirage proprement dit,

e) des réflecteurs disposés au-dessus de la cuve pour le bain fondu (3), dont la position peut être réglée par rapport à la surface du bain fondu (2),

caractérisé en ce qu'à l'extérieur de la zone de la cuve pour le bain fondu (2, 3) sont prévus un ruban muni de corps de protection (6), en forme de bandes, en un matériau résistant à la chaleur et bon conducteur du courant électrique, ainsi que des dispositifs d'entraînement et des galets de renvoi (8), à l'aide desquels le ruban (9), muni des corps de protection (6), est déplacé en synchronisme avec le corps de support (1) à revêtir (figure 2).

9. Installation suivant la revendication 8, caractérisée en ce qu'au lieu du ruban (9) entraîné en synchronisme il est prévu, en amont du dispositif de tirage proprement dit, un dispositif de garnissage par lequel les corps de protection (6) sont posés à des intervalles determinés ($L_A$) sur les bandes extérieures du ruban (1) à revêtir, et en ce qu'il est prévu un dispositif en forme de fourche par lequel les corps de protection (6) sont, après passage de la zone de cristallisation, soulevés à nouveau du ruban (1, 4).

**FIG 1**

**FIG 2**

**FIG 3**